# EUROPEAN PATENT SPECIFICATION

(11) **EP 0 645 798 B1**
(45) Date of publication and mention of the grant of the patent: **19.11.1997**
(21) Application number: 94117736.2
(22) Date of filing: 30.01.1990
(51) Int. Cl.: H01J 37/34, C23C 14/35

(54) **Magnetron sputtering apparatus**
Magnetronsputteranlage
Dispositif de pulvérisation à magnétron

(30) Priority: 30.01.1989 JP 17704/89
(43) Date of publication of application: 29.03.1995
(62) Divisional of application: 90300942.1
(73) Proprietor: MITSUBISHI KASEI CORPORATION, Tokyo (JP)
(72) Inventor: Arita, Yoji, Yokohama-shi, Nanagawa-ken (JP)
(74) Representative: Rackham, Anthony Charles

(56) References cited:
- US-A- 4 265 729
- US-A- 4 448 653
- US-A- 4 601 806

## Description

The present invention relates to a magnetron sputtering apparatus and, more particularly, to a magnetron sputtering apparatus capable of readily retaining plasma in a stable manner even in case of a large-scale magnetron or in case where target of a ferromagnetic material is sputtered. The present invention also relates to a magnetron sputtering apparatus in which local erosion of the target is blocked, thereby prolonging life of the target, and in which a variation in a sputtering rate can be made to an extremely small extent during operation.

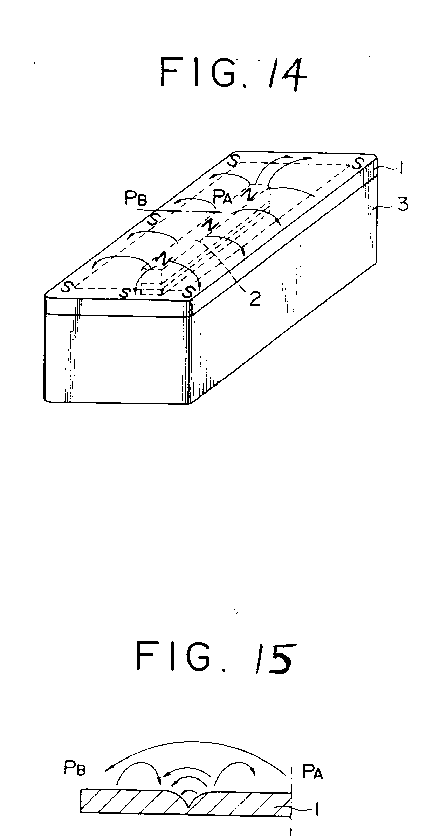

A conventional magnetron sputtering device will be described with reference to FIG. 13, in which FIG. 13(a) is a perspective view showing such a magnetron sputtering device and FIG. 13(b) is a cross-sectional view showing the magnetron sputtering device taken along line P_{A}- P_{B} of FIG. 13(a). As shown in FIG. 13, reference numeral l denotes target composed of a non-magnetic material or a ferromagnetic material. On the back side of the target l are disposed an inner magnetic pole 2 and an outer magnetic pole 3 disposed so as to enclose the inner magnet 2 and having polarity opposite to that of the inner magnetic pole 2. To their bottom portions is connected a magnetic yoke 4 composed usually of a magnetic material such as steel or the like.

The sputtering device having the foregoing configuration is accommodated in a vacuum container. When the magnetron sputtering device is in use, the container is filled with argon gas at low pressures and voltage is applied between the target and a substrate (not shown), such as a disc, thereby ionizing the argon gas and generating electrons from the target surface. The argon ions bombard the target to cause the target substance to be generated and to form a thin film on a surface of the substrate. The magnetic field formed by the two magnetic poles 2 and 3 can effectively catch the electrons and promote ionization of the argon gas, thereby improving the effectiveness of sputtering.

For conventional magnetron sputtering devices having the configuration described hereinabove, it is considered that the electrons caught around the surface of the target l are enclosed by the magnetic field formed in the shape of a semi-circular dome as indicated by arrows in Fig. 13(a) and move along the dome-like magnetic field configuration. Thus, occurrence of erosion on the surface of the target l depends upon distribution of the magnetic field over the upper surface of the target l, in other words, upon the distribution of the horizontal component and the vertical component of the magnetic field, with respect to the surface of the target. The term "vertical" is herein used to refer to a direction generally perpendicular to the plane of the target, and the term "horizontal" to a direction generally parallel to the plane of the target.

Fig. 15 is a cross-sectional view showing a typical erosion pattern of the target l in the region between P_{A} - P_{B} of Fig. 13(a) when a ferromagnetic material such as iron or cobalt, is used as the target. As is understood from this drawing, erosion develops locally and the life of the target l is shortened considerably.

Several solutions to this problem have been proposed. One of the solutions is to provide a large number of grooves on the target l extending in its longitudinal direction to thereby generate the horizontal component of the magnetic field over a full surface of the target l ("GT Target": Journal of Nippon Kinzoku Gakkai, Vol. 1, No. 25, p. 562, 1986). This technique, however, presents the disadvantage that formation of a large number of the longitudinal grooves on the target l is laborious.

We have found that a site where erosion mainly develops corresponds well to the position where the polarity of the vertical component of the magnetic field varies rather than the distribution of intensity of the horizontal component thereof, namely, to the position where the value of the vertical component thereof is very small. This is considered to be based on the fact that, as shown in Fig. 13(a), the electrons are moving in a cycle along the dome-like magnetic field over the surface of the target l as well as, at the same time, making a periodical movement in the direction of gradient in the vertical magnetic field. The number of electrons available to ionize argon gas atoms increases where the vertical component of the magnetic field becomes small. When a ferromagnetic material is used as the target, if erosion of the target l occurs, the leakage magnetic field becomes larger as shown in Fig. 15 and the gradient of the vertical magnetic field becomes larger at the location where erosion occurs, so that the intensity of the horizontal magnetic field increases, thereby further accelerating local erosion. If it is difficult to ensure the intensity of the magnetic field on the target in the case of conventional large-scale magnetron sputtering devices and sputtering devices using ferromagnetic target, there are many occasions in which an electromagnet is used for the inner and outer magnetic poles. In those occasions, however, the electromagnet presents the disadvantages that it is expensive in operating costs and the application of electricity is accompanied by the generation of heat, so that it cannot readily be applied for any device.

For the above reason, permanent magnets are desired. As the magnetic flux generally spreads over the target from the inner magnetic pole to the outer magnetic pole, the magnetic flux density around the outer magnetic pole 3 tends to be decreased compared with that around the inner magnetic pole. Thus, it is required that the magnetic flux-density of the outer magnetic pole 3 be made larger in order to keep plasma on the target stable. It is to be noted that the outer magnetic pole required for increasing the magnetic flux density comprises the total outer periphery of the magnetron in a semi-circular shape as shown in Fig. 13(a) or it is a portion of the outer magnetic pole 3 for a magnetron in a rectangular shape as shown in Fig. 14, where the magnetic flux spreads in a radial form from the inner magnetic pole 2 to the outer magnetic pole 3. When the soft magnetic material or permanent magnet is used between the inner and outer magnetic poles in order to control the distribution of the magnetic field over the target as with the present invention, this technology is particularly significant because the intensity of the magnetic field over the target is decreased. In either case, it is required that the magnetic flux density over the inner and outer magnetic poles be increased to a sufficiently high level in order to retain the plasma on the upper surface of the target in a stable manner. When the target is of a ferromagnetic material, the technique of sticking a magnet to an outer side surface of the outer magnetic pole 3 becomes significant in order to keep the high magnetic field over the upper surface of the target because the magnetic flux decreases over the upper surface of the target. For magnetrons disclosed in U.S. Patent Nos. 4,162,954 and 4,265,729, which are proposed for improvement in the distribution of erosion of the target, like the present invention, magnets are disposed such that centralization of the magnetic flux around the inner magnetic pole is prevented in order to make the magnetic lines of force as parallel as possible to the target surface over the target and the vertical component of the magnetic field is not rendered large around the inner magnetic pole. Such magnetrons present the drawbacks that plasma is likely to become unstable and, when the target is of the ferromagnetic material, the leakage magnetic field over the target surface becomes so small that no plasma is caused at all to occur.

The present invention provides a magnetron sputtering apparatus as defined in claim 1.

The invention permits magnetron sputtering apparatus to be constructed which can retain plasma on the target in a stable manner, which prevents local erosion of the target, which can significantly prolong life of the target and which can sputter the target at a stable sputtering rate during operation, particularly when ferromagnetic material is used as a target.

In preferred embodiments, each magnetic pole comprises a permanent magnet having magnetization predominantly in the vertical direction, or a soft magnetic material; and the apparatus further comprises: a first permanent magnet having magnetization predominantly in the horizontal direction, disposed between the inner and outer magnetic poles; and a second permanent magnet having magnetization predominantly in a direction opposite to the direction of the magnetization in the first permanent magnet, disposed on an outer side of the outer magnetic pole. The reader's attention is directed to European patent application number EP-A-0 381 437, from which the present application derives by division, and which describes such apparatus more generally.

The invention is hereinafter described in more detail by way of example only with reference to the accompanying drawings in which:-
Fig. 1 is a cross-sectional view showing portions of an embodiment of apparatus according to the invention;
Figs. 2(a) and 2(b) are graphs showing the distributions of the horizontal and vertical components respectively of the magnetic field over the target in a first example of apparatus according to the invention in which the target is of a ferromagnetic material;
Fig. 3 is a cross-sectional view showing an erosion pattern of the target in said first example of apparatus according to the invention;
Figs. 4(a) and 4(b) are graphs showing the distributions of the horizontal and vertical components respectively of the magnetic field over the target in a second example of apparatus according to the invention in which the target is of a ferromagnetic material;
Fig. 5 is a cross-sectional view showing an erosion pattern of the target in said second example of apparatus according to the invention;
Figs. 6(a) and 6(b) are graphs showing the distributions of the horizontal and vertical components respectively of the magnetic field over the target in a third example of apparatus according to the invention in which the target is of a non-magnetic material;
Fig. 7 is a cross-sectional view showing an erosion pattern of the target in said third example of apparatus according to the invention;
Figs. 8(a) and 8(b) are graphs showing the distributions of the horizontal and vertical components respectively of the magnetic field over the target in a fourth example of apparatus according to the invention in which the target is of a non-magnetic material;
Fig. 9 is a cross-sectional view showing an erosion pattern of the target in said fourth example of apparatus according to the invention;
Figs. 10(a) and 10(b) are graphs showing the distributions of horizontal and vertical components respectively of the magnetic field over the target in a fifth example of apparatus according to the present invention in which the target is of a non-magnetic material;
Fig. 11 is a cross-sectional view showing an erosion pattern of the target in said fifth example of apparatus according to the present invention;
Fig. 12 is a cross-sectional view showing a portion of an alternative example of apparatus according to the invention, in which a soft magnetic body divided by slits is mounted between inner and outer magnetic poles on the back side of the target of a conventional magnetron.
Figs. 13(a) and 13(b) are, respectively, a perspective view showing a conventional round magnetron, and a cross-sectional view showing the same magnetron taken along line P_{A} - P_{B} of Fig. 13(a);
Fig. 14 is a perspective view showing a conventional rectangular magnetron;
Fig. 15 is a cross-sectional view showing a typical erosion pattern formed when a ferromagnetic target is sputtered using a conventional magnetron;
Figs. 16(a) and 16(b) are graphs showing the distributions of the horizontal and vertical components respectively of the magnetic field over the target of a conventional magnetron having a target of ferromagnetic material;
Fig. 17 is a cross-sectional view showing an erosion pattern when the conventional magnetron is used, wherein the target is of ferromagnetic material;
Figs. 18(a) and 18(b) are graphs showing the distributions of the horizontal and vertical components respectively of the magnetic field over the target of a conventional magnetron having a target of a non-magnetic material; and
Fig. 19 is a cross-sectional view showing an erosion pattern formed in a conventional magnetron having a target of non-magnetic material.

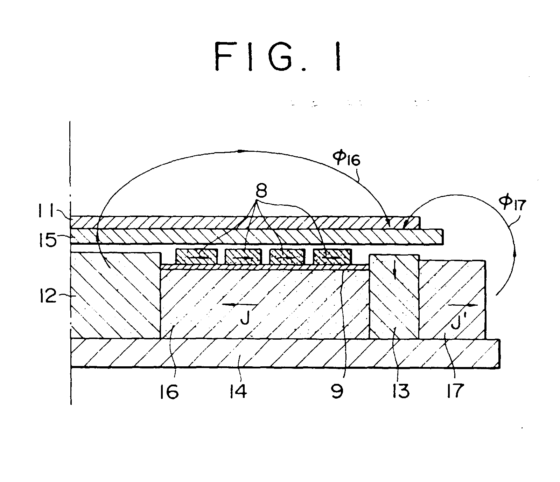

In the embodiment shown in Fig. 1, the soft magnetic body 8 is magnetized in the direction towards the outer magnetic pole by means of the magnetic field formed by the inner magnetic pole 2 and the outer magnetic pole 3. The magnetization acts over the upper surface of the target 11 in such a manner that the absolute value of the horizontal magnetic field and the gradient of the vertical magnetic field in the middle portion of both magnetic poles 12 and 13 are decreased.

On the other hand, the influence of the soft magnetic body 8 upon the magnetic field is so small that the gradient of the vertical magnetic field is increased around the upper portion of the two magnetic poles 12 and 13. The slits disposed on the soft magnetic body 8 serve to regulate the intensity of magnetization when the soft magnetic body 8 is magnetized by means of the magnetic field generated by the two magnetic poles. More specifically, it is considered that the disposition of the slits causes the magnetic flux to spring out in their positions, and the magnetic field to be generated in the opposite direction at the portions constituting the sections, thereby regulating the intensity of magnetization of the soft magnetic body. An accurate control of the distribution of the magnetic field over the upper surface of the target can be implemented by appropriately adjusting the width of the slits of the soft magnetic body 8 and controlling the intensity of magnetization at each section of the soft magnetic body 8.

In particular when a ferro magnetic body is used as the target, adjustment of the slit widths is important. In a conventional magnetron using ferromagnetic material as the target, when erosion develops on the target, the magnetic flux is caused to spring out from the target itself as shown in Figure 22 so that the magnetic field is increased at the site where erosion has developed, while this increased magnetic field decreases the magnetic field produced by the two magnetic poles on its both sides. Accordingly, the plasma is localized at the portion where erosion develops, and no plasma is caused to occur on its both sides. As a consequence, erosion proceeds with increasing velocity. When the target consisting of the ferromagnetic material develops, the magnetic field is increased under the back surface of the target as well as on the upper surface thereof. The soft magnetic body 8 has the function of preventing the magnetic field over the target from increasing as a result of an increase in magnetization of the soft magnetic body by means of the increased magnetic field. In order to have the soft magnetic body 8 serve its function well, it is necessary to optimize the magnetic characteristics of the soft magnetic body - in other words, the number of the sections of the soft magnetic body or the width of the slits disposed thereon - in accordance with the magnetic characteristics of the target or the thickness of the target. As there are gaps between the sections of the soft magnetic body 8, the gaps have the effect of adjusting the magnetic characteristics of the soft magnetic body.

For targets composed of non-magnetic material, no influence is given upon the distribution of the magnetic field by development of erosion. An appropriate adjustment of the widths of the slits permits an accurate distribution of the magnetic field over the target. This adjustment is advantageous because its adjustment is simple. It is to be noted that the slits are not necessarily divided into thoroughly separate ones and they may partially be connected to each other. In both cases, there is no significant difference of the effect. The thickness, length and magnetic characteristics of each section of the soft magnetic body are not necessarily the same as each other and they may vary as needed.

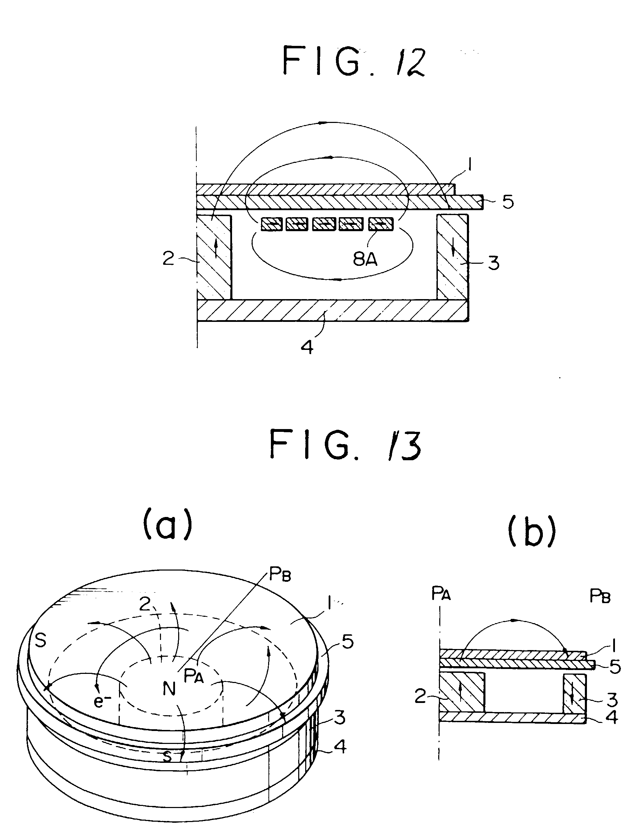

Fig. 12 shows an example in which the soft magnetic body divided by the slits is applied to the conventional magnetron as shown in Fig. 13. In this case, it is to be noted that the inner and outer magnet poles 2 and 3 should generate a sufficiently large amount of magnetic flux, and when the present invention is applied to the magnetron of such a conventional type as described hereinabove, the magnet is preferably composed of a rare earth metal, such as SmCo, NdFeB or the like, or an electromagnet.

Referring now to Fig. 1, it is seen that the magnetic body 8 composed of steel or the like is mounted on the back side of the target in a position between the two magnetic poles. Its section has substantially the same as that taken along line P_{A} - P_{B} in Fig. 13. As shown in Fig. 1, reference numerals 12 and 13 denote inner and outer magnetic poles, respectively, each consisting of soft magnetic material. A permanent magnet 16 having horizontal magnetization J is mounted between the two magnetic poles and a permanent magnet 17 having magnetization J' opposite to the magnetization J is stuck to the outer surface of the outer magnetic pole. It is to be noted herein that the magnetization may be deviated to some extent from its horizontal direction as long as its main component of the magnetization is substantially horizontal and opposite to that of the other magnetization as shown in Fig. 1. The inner and outer magnetic poles 12 and 13 may be of a permanent magnet having magnetization in the vertical direction; however, the energy product of such a permanent magnet varies so that magnetic material such as steel is preferred in order to provide an accurate distribution of the magnetic field. In particular, when the outer magnetic pole 13 requires a uniformity of the magnetic flux density around its outer periphery, use of soft magnetic material is required. FIG. 1 shows the soft magnetic body 8 that is disposed in the magnetic field and divided into four sections by slits with a narrow width ranging usually from approximately 0.01 mm to 3 mm, preferably from approximately 0.10 mm to 0.5 mm. Thicknesses of the soft magnetic body 8 range usually from about 1 mm to 10 mm, preferably from about 4 mm to 8 mm. The soft magnetic body is fixed with a support plate 9 of non-magnetic material. In the drawing, reference numeral 14 stands for a base plate consisting of non-magnetic material and reference numeral 15 for a backing plate to which the target is stuck. In the first example of FIG. 1, there is used a target of ferromagnetic material such as FeCo, having diameter of 8 inches and thickness of 2.5 mm.

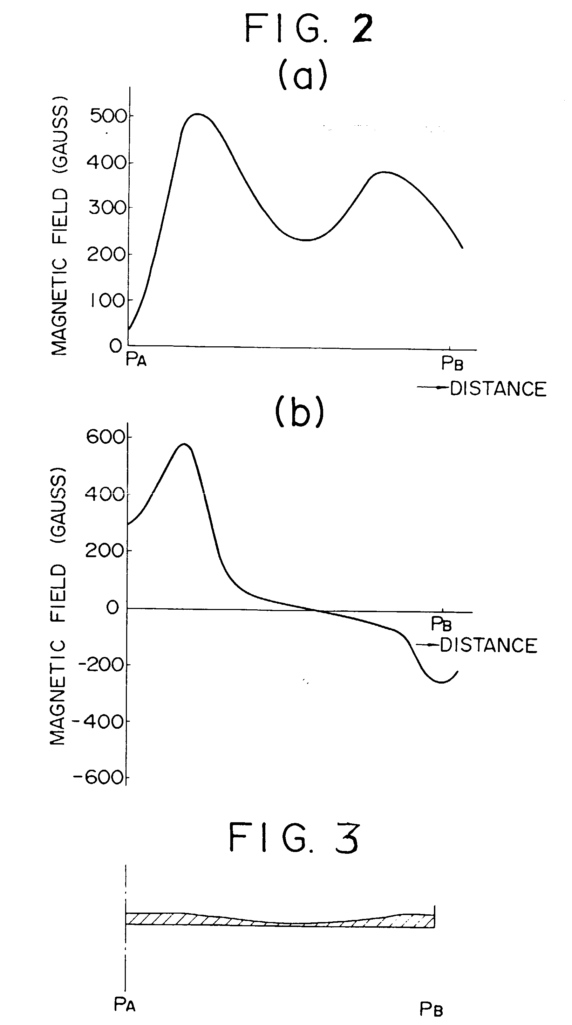

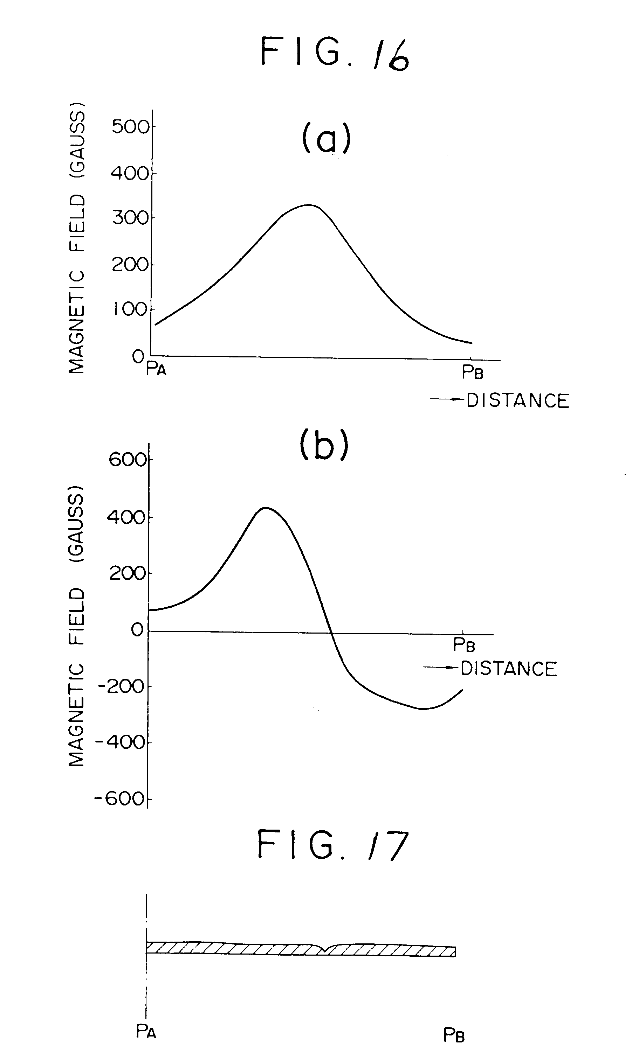

FIGS. 2(a) and 2(b) show patterns of distributions of the respective horizontal and vertical magnetic fields at 2 mm above the target surface prior to start of the sputtering when the target of ferromagnetic material is applied to the apparatus according to the present invention. FIG. 3 shows an erosion pattern of the target after the sputtering. FIGS. 16(a) and 16(b) show the same distribution patterns and FIG. 17 shows an erosion pattern in the same conditions, when the same target is applied to the conventional magnetron as shown in FIG. 12, As is apparent from FIGS. 16(a) and 16(b) and FIG. 17, erosion occurs locally for the conventional magnetron and it develops with accelerated velocity. Furthermore, it is found that the region where plasma is closed gets narrower as the erosion develops, thereby rapidly decreasing the sputtering rate as time passes. On the contrary, for the magnetron sputtering apparatus according to the present invention, erosion occurs in a wide region and the soft magnetic body 8 compensates the distribution of the magnetic field over the target as the erosion develops, thereby making a periodical variation in the sputtering rate extremely small. In the example of FIGS. 2(a), 2(b) and 3, the gradient of the vertical magnetic field around the outer magnetic pole is set to approximately 350 Gauss/cm and the gradient thereof at a central portion between the two magnetic poles is set to approximately 20 Gauss/cm. Further, it is set that polarity of the vertical magnetic field changes at a portion where the gradient of the vertical magnetic field is small - in this case, in a position extremely close to the position indicating the minimum value of an M-shaped horizontal magnetic field. In the distribution of the vertical magnetic field as shown in FIG. 2(b), the magnetic field is set to be the highest around the outside of the inner magnetic pole and to be smaller at a central portion of the inner magnetic pole. In this case, as an upper portion of the inner magnetic pole is a portion where no plasma generates, the distribution of the magnetic field at this portion is outside the present invention. In this example, the target life is prolonged by larger than five times to approximately 55 kWh from approximately 10 kWh in terms of input power, compared with a conventional magnetron as shown in FIG. 13.

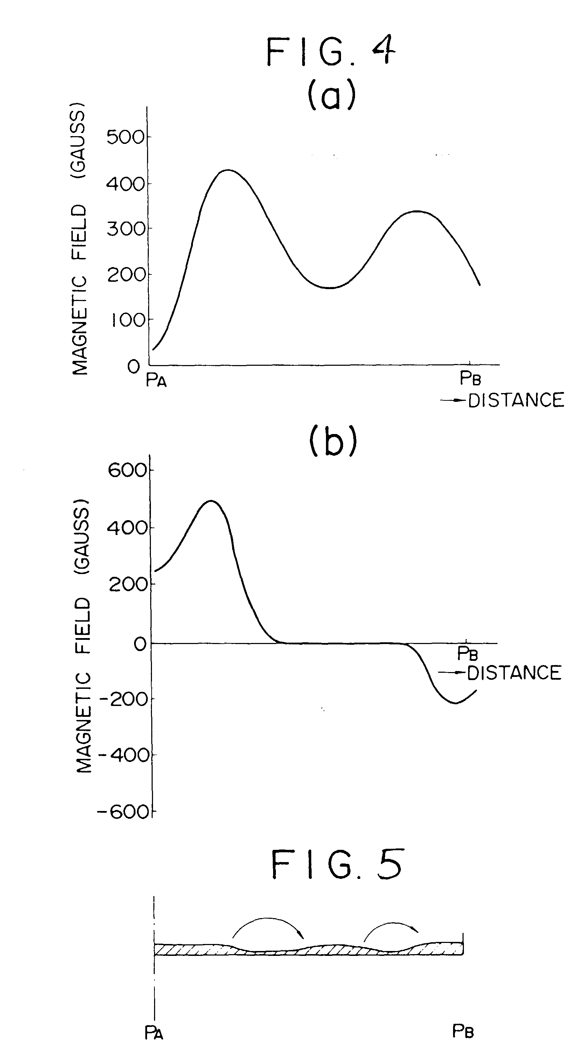

FIGS. 4(a), 4(b) and 5 represent the second example indicating the distributions of the magnetic field and an erosion pattern, respectively, wherein width of each slit of the soft magnetic body 8 is narrowed so as to make the gradient of the vertical magnetic field virtually null at a portion where the gradient of the vertical magnetic field between the magnetic poles is small. In this case, the erosion pattern is of a W-shaped form and the target life is approximately 30 kWh. This is because the erosion of the target develops with a slightly faster speed at a portion where a rise in the gradient of the vertical magnetic field is rapid and the action of compensating the magnetic field of the soft magnetic body 8 is not so large at that portion. Furthermore, it is considered to be based on the fact that plasma is confined by a partial loop of the magnetic flux from the target surface as shown in FIG. 5. Therefore, particularly when the target is of a ferromagnetic material, it is required that the gradient of the vertical magnetic field is optimized in accordance with magnetic characteristics of the target. The results of an experiment using a ferromagnetic material as the target, particularly having a large permeability, have revealed that a better result can be achieved when the gradient of the vertical magnetic field is set to an appropriately small value than when the gradient of the vertical magnetic field is set to zero. It is noted that a very good result cannot be obtained when the location where polarity of the vertical magnetic field is changed is set to the portion where the gradient of the vertical magnetic field is large and that further, when the location at which polarity of the vertical magnetic field is changed is set to a position extremely close to the position indicating the minimum value of the M-shaped horizontal magnetic field, the longest target life can be attained and a sputtering rate during operation changes at the smallest rate.

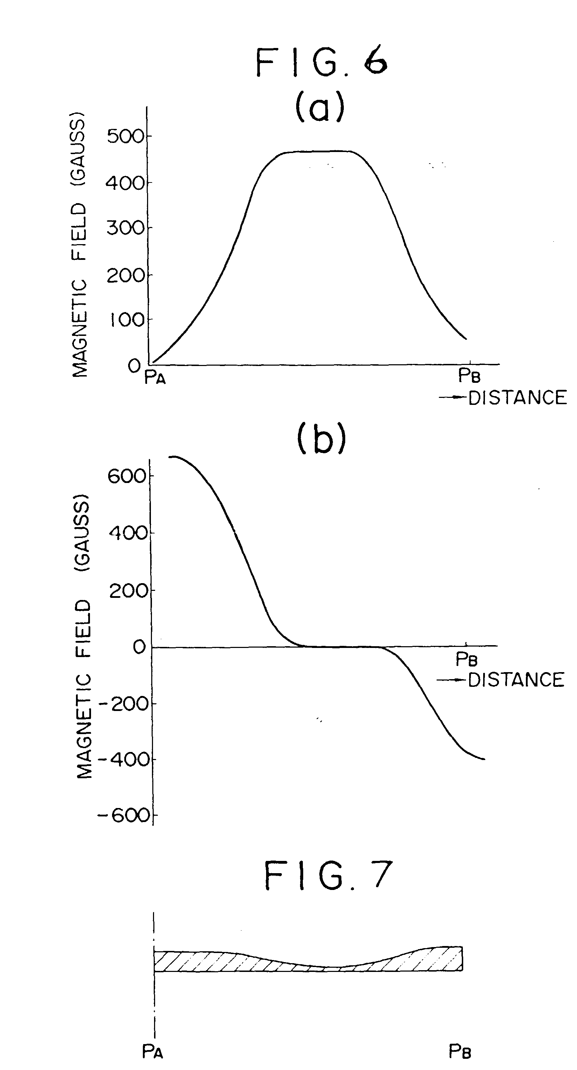

In the third example as shown in FIGS. 6(a), 6(b) and 7 , there is used the target of a Ta non-magnetic material having an 8-inch diameter and a 6-mm thickness. FIGS. 6(a), 6(b) and 7 represent the distributions of the horizontal and vertical magnetic fields at 2 mm above the target surface prior to the start of sputtering and an erosion pattern of the target subsequent to sputtering, respectively.

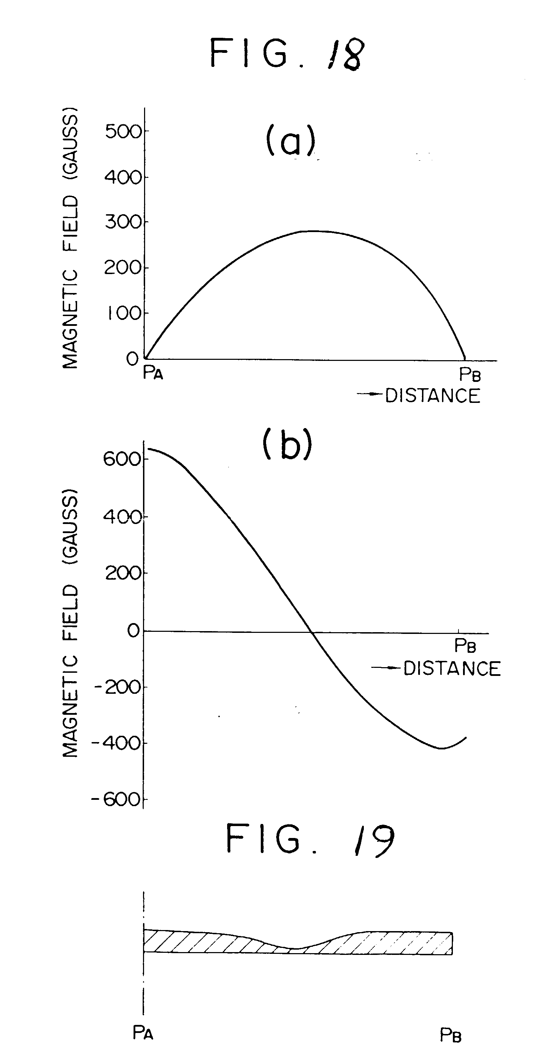

FIGS. 18(a), 18(b) and 19 represent the respective distributions of the horizontal and vertical magnetic fields at 2 mm above the target surface prior to the start of sputtering and an erosion pattern of the target subsequent to sputtering, respectively, using the same target as in the third example for a conventional magnetron as shown in Fig. 13. As is apparent from Figs. 18(a), 18(b) and 19 erosion occurs locally on the target of non-magnetic material when used with the conventional magnetron, although not so large as with the target of ferromagnetic material. In this case, a utilization efficiency of the target is approximately 25%.

In the example of FIG. 6, the soft magnetic body 8 consists of three sections and it accounts for approximately 50% of the distance between its two magnetic poles. As shown in FIGS. 6(a) and 6(b), the gradient of the vertical component of the magnetic field is set to zero at a central portion between the two magnetic poles while the gradient of the horizontal component of the magnetic field is set to a constant value. In this case, erosion occurs to a larger extent at the central portion between the magnetic poles although an erosion area spreads, as is apparent in FIG. 7. In this example, the erosion pattern is a loose U-shaped form and a utilization efficiency of the target is 41%.

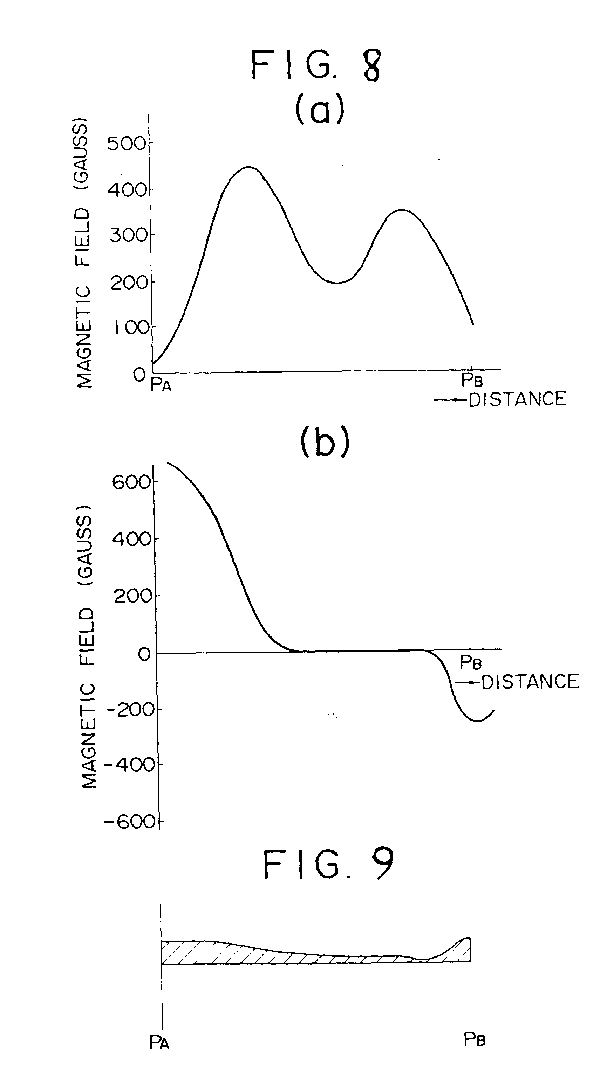

In the fourth example, the soft magnetic body 8 consists of five sections and the length of the magnetic body 8 accounts for approximately 80% of the distance between the two magnetic poles. An experiment has been conducted using the target wherein the gradient of the vertical magnetic field is set to zero at a central portion between the two magnetic poles and the horizontal component of the magnetic field is in an M-shaped form therebetween, as shown in FIGS. 8(a) and 8(b), provided however that the maximum value of the horizontal component at the central portion is set to approximately 50%. In this case; as is apparent from FIG. 9, it has been found that erosion develops in an extremely wide region and a utilization efficiency of the target is 52%. It is noted herein that erosion develops to a somewhat larger extent at a portion close to the outer magnetic pole where the gradient of the vertical magnetic field rapidly rises.

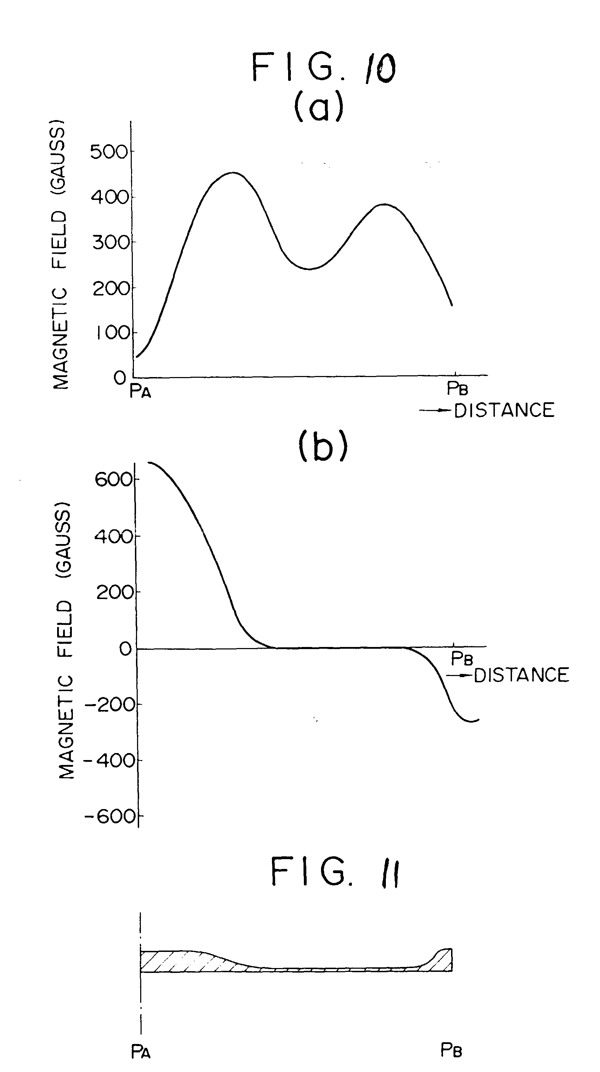

Thus, in the fifth example, the distribution of the magnetic field is set so as to allow the gradient of the vertical magnetic field to gradually rise at that portion. In this case, the width of the slit between two outer sections of the soft magnetic body 8 as shown in the fourth example is somewhat extended from 0.2 mm to 0.3 mm. The distributions of the magnetic field and an erosion pattern in this case are shown in FIGS. 10(a) and 10(b) and FIG. 11, respectively. In this case, the utilization efficiency further rises to 66%.

Although these experimental results cannot clearly be explained theoretically, it is considered that, when the plasma is confined within a dome-like magnetic field, the magnetic field nearly parallel to the target surface can be provided around a central portion between the two magnetic poles yet the plasma is thrust toward the central portion from the both sides by a larger magnetic pressure around the two magnetic poles due to a larger magnetic flux density in the vicinity of the magnetic poles, thereby making the electron concentration denser around the central portion between the two magnetic poles. In order to realize an extremely wide erosion region, thus it is considered that the magnetic flux density be somewhat smaller around the central portion between the two magnetic poles, thereby permitting the electrons to depart to some extent from the central portion.

Some experimental results have revealed that, in instances where the gradient of the vertical magnetic field is set to nearly zero, there are many occasions where an erosion distribution is changed to a nearly flat state from the U-shaped state when the distribution of intensity of the horizontal magnetic field is such that the maximum value at the central portion between the two magnetic poles ranges from approximately 20% to 75%.

It is provided, however, that there has been seen the tendency that plasma becomes unstable when the minimum value of the M-shaped horizontal magnetic field is lowered to 70 Gauss or smaller. Therefore, it is required that the minimum value for the horizontal component of the magnetic field at the central portion between the magnetic poles be 70 Gauss, preferably larger than 150 Gauss. As is apparent from the experimental results as shown in FIGS. 8 and 9, a variation in curvature of the magnetic field also is a significant factor and it is preferred that changes in the gradient of the magnetic field from a small state to a great state are not sharp.

Furthermore, it is noted that the utilization efficiency of the target cannot rise to a very high extent merely by making the direction of the magnetic field over the target parallel to the target surface, and it is thus required that the distribution of the magnetic field be optimized by observing an erosion distribution of the target.

In adjusting the width of the slit between the sections of the soft magnetic body as have been described hereinabove, it presents the advantage that the slits are disposed in somewhat larger width in advance and soft steel or the like in a ribbon form is inserted into the slits, because this technique does not require that a large number of sections of the soft magnetic body 8 be prepared. It is also preferred that an appropriate substance having a small non-permeability, such as Cu, A1 or stainless steel, or a permanent magnet having no magnetization yet a high coercive force may be inserted into the slit without leaving the slit merely as a gap, in order to permit ready positioning of the sections of the soft magnetic body 8.

Thus, the magnetron sputtering apparatus according to the present invention is provided on a back side of the target between the inner and outer magnetic poles with a means for decreasing a component of the leakage magnetic field, vertical to the target, from the inner and outer magnetic poles over a surface of the target disposed on the inner magnetic pole and a magnetic pole in the vicinity of the outer magnetic pole, at a central portion between the inner and outer magnetic poles, yet increasing the vertical component thereof at a portion around the magnetic poles, and for making the distribution of intensity of the horizontal component of the magnetic field in the M-shaped form between the magnetic poles. The provision of such a means on the back side of the target between the inner and outer magnetic poles serves as avoiding local erosion of the target and prolonging the target life to a considerable extent. In case of the target of ferromagnetic material, a variation in the sputtering rate can be minimized.

Furthermore, as have been described hereinabove, the preferred embodiment of magnetron sputtering apparatus according to the present invention is provided with the inner magnetic pole consisting of a permanent magnet having magnetization in the vertical direction or a soft magnetic material, an outer magnetic pole consisting of a similar material and disposed so as to enclose the inner magnetic pole, a permanent magnet having magnetization predominantly in the horizontal direction and disposed between the inner and outer magnetic poles, and a magnet having magnetization predominantly in a direction opposite to the horizontal direction of the permanent magnet. Thus the apparatus according to the present invention has a sufficiently large degree of the magnetic flux around the outer magnetic pole, thereby permitting plasma to be readily retained in case of a large-scale magnetron or in case where the target is of a ferromagnetic material, and thereby increasing the sputtering rate to a considerable extent, as compared with a usual magnetron.

## Claims

1. A magnetron sputtering apparatus comprising an inner magnetic pole (2/12), an outer magnetic pole (3/13) having a polarity opposite to that of the inner magnetic pole (2/12) and arranged to surround the inner magnetic pole (2/12), and a target (1/11) disposed at least above the inner magnetic pole (2/12) and extending therefrom towards the outer magnetic pole (3/13) characterized in that:
a soft magnetic material having a magnetization parallel to the plane of the target and in a direction opposite to the magnetic field generated by the inner and outer magnetic poles in the soft magnetic material and being divided into plural discrete sections (8/8A) by a substance having a narrow width and a low permeability or by slits is mounted on a back side of the target (1/11) between the inner (2/12) and outer (3/13) magnetic poles, the soft magnetic material further being adapted to decrease at a central portion between the inner (2/12) and outer (3/13) magnetic poles the gradient of the component perpendicular to the plane of the target (1/11) of the leakage magnetic field generated by the inner (2/12) and outer (3/13) magnetic poles and emerging from the surface of the target (1/11), and to increase it at a portion in the vicinity of the magnetic poles (2/12, 3/13) and to cause the distribution of intensity of the component parallel to the plane of the target (1/11) of the magnetic field between the magnetic poles to adopt an M-shaped form, having peaks towards the magnetic poles (2/12), (3/13) and a trough therebetween;
the number of the discrete sections (8/8A) of the soft magnetic material and the width of the low permeability substance or the slits being determined in accordance with the magnetic characteristics and thickness of the target.

2. A magnetron sputtering apparatus according to Claim 1, wherein each of the magnetic poles (12, 13) comprises a permanent magnet having magnetization predominantly in the direction perpendicular to the plane of the target of a soft magnetic material; the apparatus further comprising: a first permanent magnet (16) having magnetization predominantly in the direction parallel to the plane of the target in the direction of the magnetic field generated by the inner and outer magnetic poles in the permanent magnets, disposed between the inner (12) and the outer (13) magnetic poles; and a second permanent magnet (17) having magnetization predominantly in a direction opposite to the direction of the magnetization in the first permanent magnet (16) disposed on an outer side of the outer magnetic pole (13).

3. A magnetron sputtering apparatus according to Claim 1 or Claim 2, wherein the distribution of intensity of said component parallel to the plane of the target of the magnetic field in said M-shaped form is arranged such that its minimum value at the central portion between the magnetic poles (2/12, 3/13) is between 20% and 75% of its maximum value.

4. A magnetron sputtering apparatus according to any preceding claim, wherein the change in polarity of said component perpendicular to the plane of the target of the magnetic field occurs at a position between the magnetic poles (2/12, 3/13) where the gradient of said component perpendicular to the plane of the target is small.

5. A magnetron sputtering apparatus according to any preceding claim, wherein the change in polarity of said component perpendicular to the plane of the target of the magnetic field occurs at a position between the magnetic poles (2/12, 3/13) in the vicinity of the position of the minimum value of said component parallel to the plane of the target in said trough of said M-shaped distribution form.

6. A magnetron sputtering according to Claim 5, wherein said vicinity is defined as the actual position of the minimum value of said component parallel to the plane of the target, plus and minus 10% of the distance between the magnetic poles (2/12, 3/13).

7. A magnetron sputtering apparatus according to any preceding claim, wherein a soft magnetic material in the form of a ribbon is inserted into the slit(s), thereby to adjusting the width thereof.

8. A magnetron sputtering apparatus according to any preceding claim, wherein the target is of ferromagnetic material.

## Patentansprüche

1. Magnetronzerstäubungsanlage, umfassend einen inneren Magnetpol (2/12), einen äußeren Magnetpol (3/13) mit einer Polarität, die derjenigen des inneren Magnetpols (2/12) entgegengesetzt ist, und so angeordnet, daß er den inneren Magnetpol (2/12) umgibt, und ein Target (1/11), welches zumindest oberhalb des inneren Magnetpols (2/12) angeordnet ist und sich von dort aus in Richtung des äußeren Magnetpols (3/13) erstreckt,
**dadurch gekennzeichnet**, daß
ein weichmagnetisches Material mit einer Magnetisierung parallel zu der Ebene des Targets und in einer Richtung entgegen dem Magnetfeld, welches von dem inneren und dem äußeren Magnetpol in dem weichmagnetischen Material erzeugt wird, und mit Unterteilung in mehrere diskrete Abschnitte (8/8A) durch eine Substanz geringer Breite und niedriger Permeabilität, oder durch Schlitze, auf einer Rückseite des Targets (1/11) zwischen dem inneren (2/12) und dem äußeren (3/13) Magnetpol angeordnet ist, das weichmagnetische Material außerdem in der Lage ist, in einer mittleren Zone zwischen dem inneren (2/12) und dem äußeren (3/13) Magnetpol den Gradienten der Komponente senkrecht zu der Ebene des Targets (1/11) des magnetischen Streufelds zu verringern, welches von dem inneren (2/12) und dem äußeren (3/13) Magnetpol erzeugt wird und aus der Oberfläche des Targets (1/11) hervortritt, und es in einem Bereich in der Nähe der Magnetpole (2/12, 3/13) zu erhöhen und zu veranlassen, daß die Intensitätsverteilung der Komponente parallel zur Ebene des Targets (1/11) des Magnetfelds zwischen den Magnetpolen eine M-förmige Verteilung mit Spitzen in Richtung der Magnetpole (2/12), (3/13) und einer Mulde dazwischen annimmt;
wobei die Anzahl der diskreten Abschnitte (8/8A) des weichmagnetischen Materials und die Breite der Substanz niedriger Permeabilität oder der Schlitze bestimmt sind nach Maßgabe der magnetischen Kennlinie und der Dicke des Targets.

2. Magnetzerstäubungsanlage nach Anspruch 1, bei der jeder der Magnetpole (12, 13) einen Permanentmagneten mit einer Magnetisierung vorherrschend in Richtung senkrecht zur Ebene des Targets aus weichmagnetischem Material aufweist und die Anlage außerdem enthält: einen ersten Permanentmagneten (16) mit einer Magnetisierung vorherrschend in der Richtung parallel zur Ebene des Targets in Richtung des magnetischen Felds, welches von dem inneren und dem äußeren Magnetpol in den Permanentmagneten erzeugt wird, angeordnet zwischen dem inneren (12) und dem äußeren (13) Magnetpol; und einen zweiten Permanentmagneten (17) mit einer Magnetisierung vorherrschend in eine Richtung entgegen der Magnetisierungsrichtung in dem ersten Permanentmagneten (16), angeordnet auf einer Außenseite des äußeren Magnetpols (13).

3. Magnetronzerstäubungsanlage nach Anspruch 1 oder Anspruch 2, bei der die Verteilung der Intensität der Komponente rechtwinklig zur Ebene des Targets des Magnetfelds M-förmiger Verteilung so angeordnet ist, daß ihr Minimumwert in dem mittleren Bereich zwischen den Magnetpolen (2/12, 3/13) zwischen 20% und 75% des Maximalwerts ausmacht.

4. Magnetronzerstäubungsanlage nach einem vorhergehenden Anspruch, bei der die Änderung der Polarität der Komponente senkrecht zur Ebene des Targets des Magnetfelds an einer Stelle zwischen den Magnetpolen (2/12, 3/13) erfolgt, an der der Gradient der Komponente rechtwinklig zur Ebene des Targets klein ist.

5. Magnetronzerstäubungsanlage nach einem vorhergehenden Anspruch, bei der die Änderung der Polarität der Komponente senkrecht zur Ebene des Targets des Magnetfelds an einer Stelle zwischen den Magnetpolen (2/12, 3/13) in der Nähe der Stelle des Minimalwerts der Komponente parallel zur Ebene des Targets in der Mulde der M-förmigen Verteilung stattfindet.

6. Magnetronzerstäubungsanlage nach Anspruch 5, bei der die Nähe definiert ist als die Ist-Position des Minimumwerts der Komponente parallel zur Ebene des Targets, plus und minus 10% der Distanz zwischen den Magnetpolen (2/12, 3/13).

7. Magnetronzerstäubungsanlage nach einem vorhergehenden Anspruch, bei der ein weichmagnetisches Material in Form eines Bandes in den Schlitz (die Schlitze) eingefügt ist, um dadurch deren Breite zu justieren.

8. Magnetronzerstäubungsanlage nach einem vorhergehenden Anspruch, bci dcr das Target aus ferromagnetischem Material besteht.

## Revendications

1. Dispositif de pulvérisation cathodique à magnétron comprenant un pôle magnétique intérieur (2/12), un pôle magnétique extérieur (3/13) ayant une polarité opposée à celle du pôle magnétique intérieur (2/12) et disposé de manière à entourer le pôle magnétique intérieur (2/12), et une cible (1/11) disposée au moins au-dessus du pôle magnétique intérieur (2/12) et se prolongeant à partir de là vers le pôle magnétique extérieur (3/13), caractérisé en ce que :
un matériau magnétique tendre ayant une magnétisation parallèle au plan de la cible et dans une direction opposée au champ magnétique créé par les pôles magnétiques intérieur et extérieur dans le matériau magnétique tendre et étant divisé en plusieurs sections discrètes (8/8A) par une substance ayant une faible largeur et une faible perméabilité ou par des fentes est monté sur un côté arrière de la cible (1/11) entre les pôles magnétiques intérieur (2/12) et extérieur (3/13), le matériau magnétique tendre étant en outre adapté pour diminuer à une partie centrale entre les pôles magnétiques intérieur (2/12) et extérieur (3/13) le gradient de la composante perpendiculaire au plan de la cible (1/11) du champ magnétique de fuite créé par les pôles magnétiques intérieur (2/12) et extérieur (3/13) et émergeant de la surface de la cible (1/11), et pour l'augmenter à une partie voisine des pôles magnétiques (2/12, 3/13) et causer la distribution d'intensité de la composante parallèle au plan de la cible (1/11) du champ magnétique entre les pôles magnétiques pour adopter une forme en M, ayant des crêtes en direction des pôles magnétiques (2/12), (3/13) et un creux entre eux;
le nombre de sections discrètes (8/8A) du matériau magnétique tendre et la largeur de la substance à faible perméabilité ou des fentes étant déterminés conformément aux caractéristiques magnétiques et à l'épaisseur de la cible.

2. Dispositif de pulvérisation cathodique à magnétron selon la Revendication 1, dans lequel chacun des pôles magnétiques (12, 13) comprend un aimant permanent ayant une magnétisation prédominante dans la direction perpendiculaire au plan de la cible d'un matériau magnétique tendre; le dispositif comprenant en outre : un premier aimant permanent (16) ayant une magnétisation prédominante dans la direction parallèle au plan de la cible dans la direction du champ magnétique créé par les pôles magnétiques intérieur et extérieur dans les aimants permanents, disposé entre les pôles magnétiques intérieur (12) et extérieur (13); et un deuxième aimant permanent (17) ayant une magnétisation prédominante dans une direction opposée à la direction de la magnétisation dans le premier aimant permanent (16) disposé sur un côté extérieur du pôle magnétique extérieur (13).

3. Dispositif de pulvérisation cathodique à magnétron selon la Revendication 1 ou la Revendication 2, dans lequel la distribution d'intensité de ladite composante parallèle au plan de la cible du champ magnétique dans ladite forme en M est agencée de telle sorte que sa valeur minimale à la partie centrale entre les pôles magnétiques (2/12, 3/13) est entre 20% et 75% de sa valeur maximale.

4. Dispositif de pulvérisation cathodique à magnétron selon l'une quelconque des revendications précédentes, dans lequel le changement de polarité de ladite composante perpendiculaire au plan de la cible du champ magnétique intervient à une position entre les pôles magnétiques (2/12, 3/13) où le gradient de ladite composante perpendiculaire au plan de la cible est faible.

5. Dispositif de pulvérisation cathodique à magnétron selon l'une quelconque des revendications précédentes, dans lequel le changement de polarité de ladite composante perpendiculaire au plan de la cible du champ magnétique intervient à une position entre les pôles magnétiques (2/12, 3/13) voisine de la position de la valeur minimale de ladite composante parallèle au plan de la cible dans ledit creux de ladite forme de distribution en M.

6. Dispositif de pulvérisation cathodique à magnétron selon la Revendication 5, dans lequel ladite position voisine est définie comme la position effective de la valeur minimale de ladite composante parallèle au plan de la cible, plus et moins 10% de la distance entre les pôles magnétiques (2/12, 3/13).

7. Dispositif de pulvérisation cathodique à magnétron selon l'une quelconque des revendications précédentes, dans lequel un matériau magnétique tendre sous forme de ruban est introduit dans la ou les fentes, pour en ajuster ainsi la largeur.

8. Dispositif de pulvérisation cathodique à maqnétron selon l'une quelconque des revendications précédentes, dans lequel la cible est en matériau ferromagnétique.
